Europäisches Patentamt

European Patent Office

Office européen des brevets

(11) Veröffentlichungsnummer: **0 415 186 A1**

## (12) EUROPÄISCHE PATENTANMELDUNG

(21) Anmeldenummer: 90115664.6

(22) Anmeldetag: 16.08.90

(51) Int. Cl.⁵: **H03M 1/74, H03M 1/66**

(30) Priorität: 31.08.89 DE 3928886

(43) Veröffentlichungstag der Anmeldung:
**06.03.91 Patentblatt 91/10**

(84) Benannte Vertragsstaaten:
**DE FR GB IT SE**

(71) Anmelder: **Blaupunkt-Werke GmbH**
**Robert-Bosch-Strasse 200**
**W-3200 Hildesheim(DE)**

(72) Erfinder: **Aust, Hans-Ulrich, Dr.**
**Am Nottbohm 8**
**W-3200 Hildesheim(DE)**

(74) Vertreter: **Eilers, Norbert, Dipl.-Phys.**
**Blaupunkt-Werke GmbH**
**Robert-Bosch-Strasse 200**
**W-3200 Hildesheim(DE)**

(54) Schaltungsanordnung zur Digital/Analog-Wandlung.

(57) Bei einer Schaltungsanordnung zur Digital/Analog-Wandlung eines digitalen Signals hoher Amplitudenauflösung, insbesondere eines Audiosignals, sind mehrere Digital/Analog-Wandler (DAC1-DACK) vorgesehen, denen in einer ersten Betriebsart jeweils eine Gruppe der Binärstellen des digitalen Signals zuführbar ist und deren Ausgangssignale unter Berücksichtigung der Werte der jeweiligen Binärstellen addiert werden. Die Digital/Analog-Wandler weisen mindestens jeweils eine Binärstelle mehr auf als eine Gruppe. Die Wertebereiche der Ausgangssignale der Digital/Analog-Wandler überlappen sich entsprechend. In einer zweiten Betriebsart werden jeweils zwei Digital/Analog-Wandler, die bezüglich der Wertebereiche ihrer Ausgangssignale benachbart sind, derart angesteuert, daß ihre Ausgangssignale im überlappenden Bereich liegen. Durch Differenzbildung der dabei entstehenden Ausgangssignale beider Digital/Analog-Wandler wird eine Korrekturspannung erzeugt, die dem Ausgangssignal eines der Wandler im Sinne einer Minimierung der Differenz hinzugefügt wird.

Fig. 1

## SCHALTUNGSANORDNUNG ZUR DIGITAL/ANALOG-WANDLUNG

Die Erfindung geht aus von einer Schaltungsanordnung zur Digital/Analog-Wandlung nach der Gattung des Hauptanspruchs.

Bei der digitalen Übertragung von Analogsignalen hat die Amplitudenauflösung bzw. die Anzahl der zu übertragenden Binärstellen für jeweils einen Abtastwert eine erhebliche Bedeutung für die Übertragungsqualität. Das gleiche gilt für die Aufzeichnung und Wiedergabe von Analogsignalen mit digitalen Verfahren. Mit steigender Amplitudenauflösung ist jedoch ein größerer Schaltungsaufwand erforderlich, was unter anderem für Schaltungen zur Digital/Analog-Wandlung gilt.

Aufgabe der vorliegenden Erfindung ist es, eine Schaltungsanordnung zur Digital/Analog-Wandlung hoher Auflösung, insbesondere für Audiosignale, anzugeben, bei welcher einfache Digital/Analog-Wandler mit geringerer Auflösung verwendet werden können.

Die erfindungsgemäße Schaltungsanordnung mit den kennzeichnenden Merkmalen des Hauptanspruchs weist den Vorteil auf, daß sich eine hohe Amplitudenauflösung durch Zusammenschalten mehrerer Digital/Analog-Wandler geringerer Auflösung ergibt, ohne daß dabei Unstetigkeitsstellen in dem analogen Ausgangssignal der erfindungsgemäßen Schaltungsanordnung entstehen.

Durch die in den Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1 ein Blockschaltbild einer erfindungsgemäßen Schaltungsanordnung mit eienr beliebigen Anzahl von Digital/Analog-Wandlern,

Fig. 2 ein Blockschaltbild einer erfindungsgemäßen Schaltungsanordnung mit zwei Digital/Analog-Wandlern und

Fig. 3 ein Ausführungsbeispiel für die in der Schaltungsanordnung nach Fig. 2 verwendete Koppel-und Steuerschaltung im Falle einer Binär-Darstellung der zu wandelnden digitalen Signale und

Fig. 4 ein Ausführungsbeispiel für die in der Schaltungsanordnung nach Fig. 2 verwendete Koppel-und Steuerschaltung im Falle einer Zweier-Komplement-Darstellung der zu wandelnden digitalen Signale.

Gleiche Teile sind in den Figuren mit gleichen Bezugszeichen versehen.

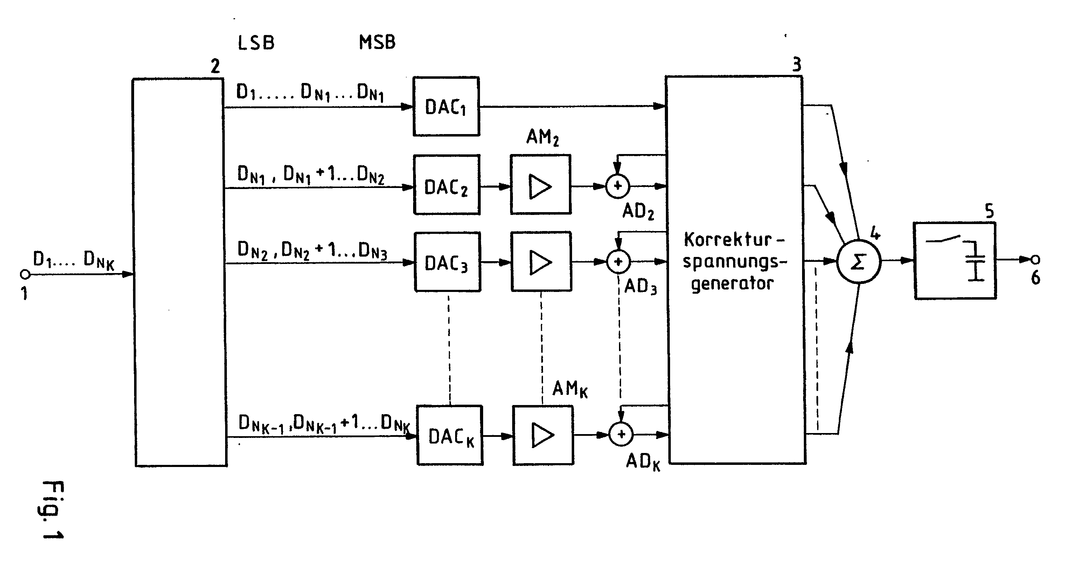

Der Schaltungsanordnung nach Fig. 1 werden bei 1 digitale Signale zugeführt, welche die Binärstellen $D_1$ bis $D_{Nk}$ umfassen. In einer Koppeleinheit 2 werden die Binärstellen auf mehrere Digital/Analog-Wandler $DAC_1$ bis $DAC_k$ verteilt. Den Digital/Analog-Wandlern $DAC_2$ bis $DAC_k$ ist jeweils ein Verstärker $AM_2$ bis $AM_k$ nachgeschaltet. Die Ausgänge der Verstärker $AM_2$ bis $AM_k$ sind über je eine Addierschaltung $AD_2$ bis $AD_k$ mit Eingängen eines Korrekturspannungsgenerators 3 verbunden. Der Ausgang des Digital/Analog-Wandlers $DAC_1$ ist an einen weiteren Eingang des Korrekturspannungsgenerators 3 angeschlossen. Eine Summierschaltung 4 ist zur Addition der Ausgangssignale der Addierschaltungen $AD_2$ bis $AD_k$ und des Digital/Analog-Wandlers $DAC_1$ vorgesehen. An den Ausgang der Summierschaltung 4 ist eine Abtast- und Halteschaltung 5 angeschlossen, an derem Ausgang 6 das Analogsignal zur Verfügung steht.

Bei der erfindungsgemäßen Schaltungsanordnung ist eine Wandlerbetriebsart und eine Kompensationsbetriebsart vorgesehen. Bei der Wandlerbetriebsart werden den Digital/Analog-Wandlern $DAC_1$ bis $DAC_k$ die Binärstellen des digitalen Signals wie folgt zugeführt: Der Digital/Analog-Wandler $DAC_1$ erhält die Binärstellen $D_1$ bis $D_{N1}$, der Digital/Analog-Wandler $DAC_2$ die Binärstellen $D_{N1+1}$ bis $D_{N2}$, der Digital/Analog-Wandler $DAC_3$ die Binärstellen $D_{N2+1}$ bis $D_{N3}$ usw.. Die jeweils geringstwertige Stelle der Eingänge der Digital/Analog-Wandler $DAC_2$ bis $DAC_k$ wird nicht angesprochen.

Da durch Exemplarstreuungen und unterschiedliche Temperaturabhängigkeiten die Ausgangsspannungen der Digital/Analog-Wandler verschiedene Gleichspannungslagen (Offsets) aufweisen können, wird mit Hilfe der Addierschaltungen $AD_2$ bis $AD_k$ eine Korrekturspannung den verstärkten Ausgangsspannungen der Digital/Analog-Wandler $DAC_2$ bis $DAC_k$ hinzugefügt. Die Größe dieser Korrekturspannungen wird derart geregelt, daß die Ausgangsspannungen der einzelnen Digital/Analog-Wandler ohne Sprünge aneinander angeglichen sind.

Zur Ableitung der Korrekturspannungen wird die Schaltungsanordnung nach Fig. 1 in eine Kompensationsbetriebsart geschaltet. Dieses erfolgt kurzzeitig, so daß der Betrieb als Digital/Analog-Wandler nicht gestört wird. In der Kompensationsbetriebsart wird im Falle einer Zweier-Komplement-Darstellung der digitalen Signale dem Digital/Analog-Wandler $DAC_1$ der Wert $1000_{hex}$ und dem Digital/Analog-Wandler $DAC_2$ der Wert $7F_{hex}$ zugeführt.

Im Falle einer Binär-Darstellung der digitalen Signale werden die dem Digital/Analog-Wandler $DAC_1$ zugeführten Binärstellen $D_1$ bis $D_{N1-1}$ auf 0 gesetzt, während die Binärstelle $D_{N1}$ den Wert 1 erhält. Gleichzeitig werden dem Digital/Analog-Wandler DAC$_2$ die Binärstellen $D_{N1} = 1$, $D_{N1} + 1$ bis $D_{N2} = 0$ zugeführt.

Mit Hilfe des Korrekturspannungsgenerators wird die Korrekturspannung, welche der Addierschaltung AD$_2$ zugeführt wird, derart geregelt, daß die Ausgangsspannungen des Digital/Analog-Wandlers DAC$_1$ und der Addierschaltung 2 gleich sind. In entsprechender Weise werden die Gleichspannungswerte der Digital/Analog-Wandler DAC$_3$ bis DAC$_k$ an den jeweils vorangegangenen Digital/Analog-Wandler angepaßt.

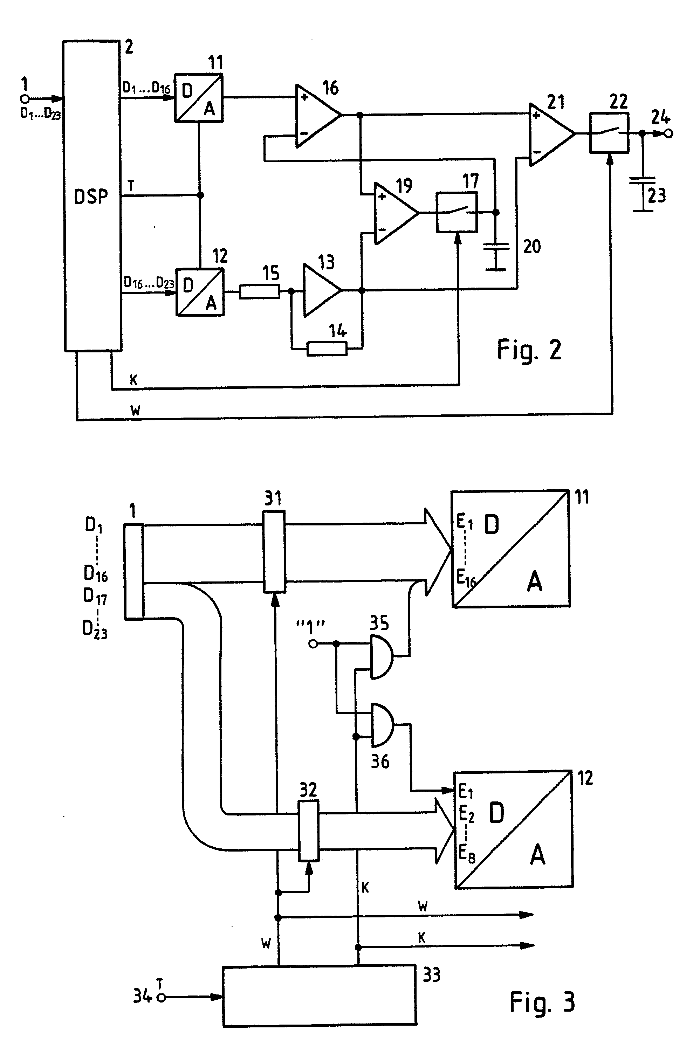

Bei der Schaltungsanordnung nach Fig. 2 erfolgt die Verteilung der Binärstellen des digitalen Signals auf zwei Digital/Analog-Wandler 11, 12 mit Hilfe eines digitalen Signalprozessors 10, der entsprechend programmiert ist.

Außerdem erzeugt der digitale Signalprozessor ein Signal K, welches in der Kompensationsbetriebsart den Wert 1 annimmt, und ein Signal W, welches in der Wandlerbetriebsart 1 ist. Die analogen Ausgangssignale des Digital/Analog-Wandlers 12 werden um einen konstanten Faktor verstärkt, wozu ein Verstärker 13 vorgesehen ist, der mit Hilfe der Widerstände 14 und 15 zur Erreichung einer konstanten Verstärkung gegengekoppelt ist.

Die Funktion einer der Addierschaltungen AD (Fig. 1) übernimmt bei der Schaltungsanordnung nach Fig. 2 ein Differenzverstärker 16, dessem nichtinvertierenden Eingang das Ausgangssignal des Digital/Analog-Wandlers 11 zugeführt wird und dessen Verstärkung $V = 1$ ist. Die Ausgänge der Verstärker 13 und 16 sind mit den Eingängen eines weiteren Differenzverstärkers 19 verbunden, an dessen Ausgang über einen elektronischen Schalter 17 ein Speicherkondensator 20 und der invertierende Eingang des Differnezverstärkers 16 angeschlossen sind.

Während der Kompensationsbetriebsart steuert das Signal K den Schalter 17 in den leitenden Zustand, so daß der weitere Differenzverstärker 19 die Differenz zwischen den Ausgangsspannungen der Verstärker 13 und 16 verstärkt und dem invertierenden Eingang des Differenzverstärkers 16 zuführt. Nach einem Einschwingvorgang der Regelung steht am Kondensator 20 eine Spannung an, die eine Angleichung der Ausgangsspannung des Differenzverstärkers 16 an diejenige des Verstärkers 13 bewirkt. Diese Spannung wird als Korrekturspannung für die anschließende Wandlerbetriebsart gespeichert, wozu der Schalter 17 in den nichtleitenden Zustand geschaltet wird.

Bei der Wandlerbetriebsart geben die Digital/Analog-Wandler entsprechend den Daten an ihren Eingängen jeweils ein Analogsignal ab, wobei das Ausgangssignal des Digital/Analog-Wandlers 11 mit Hilfe der Korrekturspannung korrigiert wird.

Beide Analogsignale werden dann in einer Summierschaltung 21 addiert und einer Abtast- und Halteschaltung zugeführt, welche aus einem Schalter 22 und einem Kondensator 23 besteht. Der Schalter 22 ist während der Wandlerbetriebsart geschlossen, so daß sich der Kondensator 23 auf die Summe der von den Wandlern erzeugten Analogsignale aufladen kann und die Ladung während der Kompensationsbetriebsart beibehält. Am Ausgang 24 kann das Analogsignal abgenommen und einer weiteren Verwendung zugeführt werden.

Zur weiteren Erläuterung der Verteilung der Binärstellen des digitalen Signals auf die Digital/Analog-Wandler 11 und 12 ist in Fig. 3 ein Beispiel für eine Koppel- und Steuerschaltung dargestellt, die anstelle des digitalen Signalprozessors 10 (Fig. 2) bei binär codierten Signalen verwendet werden kann. Vom Eingang 1 werden die Binärstellen $D_1$ bis $D_{16}$ einem ersten Bustreiber 31 zugeführt, während ein zweiter Bustreiber 32 für die Binärstellen $D_{17}$ bis $D_{23}$ vorgesehen ist. Der Bustreiber 31 ist an Eingänge $E_1$ bis $E_{16}$ des Digital/Analog-Wandlers 11 angeschlossen, während die Ausgänge des Bustreibers 32 mit Eingängen $E_2$ bis $E_8$ des Digital/Analog-Wandlers 12 verbunden sind. Eine Steuerschaltung 33 erzeugt aus einem bei 34 zugeführten Taktsignal T die Signale W und K, welche während einer Taktperiode des Taktsignals T jeweils abwechselnd den Wert 1 annehmen.

In der Wandlerbetriebsart steuert das Signal W die Bustreiber 31, 32 in den leitenden Zustand, so daß die digitalen Signale wie beschrieben den Digital/Analog-Wandlern zugeführt werden. In der Kompensationsbetriebsart dagegen sind die Bustreiber 31, 32 gesperrt, während das Signal K über zwei Und-Schaltungen 35, 36 ein Signal "1" dem Eingang $E_{16}$ des Digital/Analog-Wandlers 11 und dem Eingang $E_1$ des Digital/Analog-Wandlers 12 zuführt. Die Kompensation als solche erfolgt in der im Zusammenhang mit Fig. 2 beschriebenen Weise.

Bei dem in Fig. 3 dargestellten Ausführungsbeispiel ist vorgesehen, daß während einer jeden Taktperiode jeweils nacheinander W und K den Wert 1 annehmen, daß also außer dem Wandlerbetrieb während jeder Taktperiode eine Ableitung der Korrekturspannung erfolgt. Je nach Voraussetzungen im einzelnen, kann die Ableitung der Korrekturspannung auch weniger häufig erfolgen, da sich die zu kompensierenden Fehler nur langsam ändern. Bei mehr als zwei Digital/Analog-Wandlern erfolgt der Abgleich nacheinander in Richtung zu den Digital/Analog-Wandlern für die höherwertigen Binärstellen.

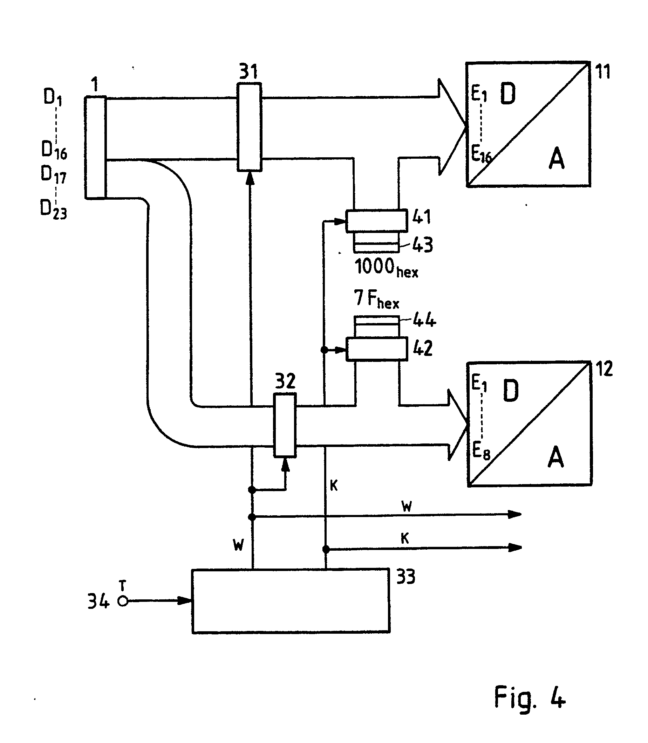

Fig. 4 zeigt eine Koppel- und Steuerschaltung für den Fall einer Zweier-Komplement-Darstellung. Die Teile 31 bis 34 sind bereits im Zusammenhang mit Fig. 3 beschrieben. Über weitere Bustreiber 41, 42 werden in der Kompensationsbetriebsart von Eingängen 43, 44 den Digital/Analog-Wandlern 11, 12 die Werte $1000_{hex}$ und $7F_{hex}$ zugeführt.

Bei der Verwendung von zwei erfindungsgemäßen Schaltungsanordnungen in einer stereophonen Wiedergabeeinrichtung kann der Abgleich in jeweils einem Kanal durchgeführt werden, wenn im anderen Kanal der Wandlerbetrieb erfolgt.

## Ansprüche

1. Schaltungsanordnung zur Digital/Analog-Wandlung eines digitalen Signals hoher Amplitudenauflösung, insbesondere eines Audiosignals, dadurch gekennzeichnet, daß mehrere Digital/Analog-Wandler ($DAC_1$ ... $DAC_k$) vorgesehen sind, denen in einer ersten Betriebsart jeweils eine Gruppe der Binärstellen des digitalen Signals zuführbar ist und deren Ausgangssignale unter Berücksichtigung der Werte der jeweiligen Binärstellen addiert werden, daß die Digital/Analog-Wandler ($DAC_2$ ... $DAC_k$) mindestens jeweils eine Binärstelle mehr aufweisen als eine Gruppe und sich die Wertebereiche der Ausgangssignale der Digital/Analog-Wandler entsprechend überlappen, daß in einer zweiten Betriebsart jeweils zwei Digital/Analog-Wandler, die bezüglich der Wertebereiche ihrer Ausgangssignale benachbart sind, derart angesteuert werden, daß ihre Ausgangssignale im überlappenden Bereich liegen, und daß durch Differenzbildung der dabei entstehenden Ausgangssignale beider Digital/Analog-Wandler eine Korrekturspannung erzeugt wird, die dem Ausgangssignal eines der Wandler im Sinne einer Minimierung der Differenz hinzugefügt wird.

2. Schaltungsanordnung nach Anspruch 1, dadurch gekennzeichnet, daß die erste und die zweite Betriebsart abwechselnd eingenommen werden.

3. Schaltungsanordnung nach Anspruch 1, dadurch gekennzeichnet, daß bei Vorhandensein von mehr als zwei Digital/Analog-Wandlern ($DAC_1$ ... $DAC_k$) in der zweiten Betriebsart zunächst eine Korrekturspannung für den Digital/Analog-Wandler ($DAC_2$) der zweitgeringstwertigen Gruppe gebildet wird und daß danach für die weiteren Digital/Analog-Wandler ($DAC_3$ ... $DAC_k$) in der Reihenfolge einer aufsteigenden Wertigkeit Korrekturspannungen erzeugt werden.

4. Schaltungsanordnung nach Anspruch 1, dadurch gekennzeichnet, daß das digitale Signal über eine Koppeleinheit (2) den Eingängen der Digital/Analog-Wandler ($DAC_1$ ... $DAC_k$) zuführbar ist, daß Ausgänge der Digital/Analog-Wandler ($DAC_2$ ... $DAC_k$) gegebenenfalls über je einen Verstärker mit je einem ersten Eingang einer Addierschaltung ($AD_2$ ... $AD_k$) verbunden sind, daß den zweiten Eingängen der Addierschaltungen Korrekturspannungen zuführbar sind und daß die Addierschaltungen ($AD_2$ ... $AD_k$) ausgangsseitig über eine Summierschaltung (4) an eine Abtast- und Halteschaltung (5) angeschlossen sind.

5. Schaltungsanordnung nach Anspruch 1, dadurch gekennzeichnet, daß zur Wandlung eines digitalen Signals mit 23 Binärstellen ein erster Digital/Analog-Wandler (12) mit acht Binärstellen und ein zweiter Digital/Analog-Wandler (11) mit 16 Binärstellen vorgesehen sind, daß der Ausgang des ersten Digital/Analog-Wandlers (12) mit dem Eingang eines Verstärkers (13) und der Ausgang des zweiten Digital/Analog-Wandlers (11) mit einem ersten Eingang eines Subtrahierers (16) verbunden ist, daß die Ausgänge des Verstärkers (13) und des Subtrahierers (16) einerseits mit Eingängen eines Differenzverstärkers (19), an dessen Ausgang über einen steuerbaren Schalter (17) ein Speicherkondensator (20) und ein weiterer Eingang des Subtrahierers angeschlossen sind und andererseits mit den Eingängen einer Addierschaltung (21) verbunden sind, an deren Ausgang eine Abtast- und Halteschaltung (22, 23) angeschlossen ist.

Fig. 1

Fig. 2

Fig. 3

Fig. 4

## EINSCHLÄGIGE DOKUMENTE

EP 90115664.6

| Kategorie | Kennzeichnung des Dokuments mit Angabe, soweit erforderlich, der maßgeblichen Teile | Betrifft Anspruch | KLASSIFIKATION DER ANMELDUNG (Int Cl⁵) |
|---|---|---|---|
| A | GB - A - 2 203 305 (RYOICHI MORI) * Seite 9, Zeile 13 - Seite 10, Zeile 27; Fig. 6 * -- | 1 | O 03 M 1/74 H 03 M 1/66 |
| A | GB - A - 2 212 367 (ICL) * Fig. 1; Seite 2, Zeile 21 - Seite 3, Zeile 23a * -- | 1 | |
| A | US - A - 4 677 581 (MALKA et al.) * Ansprüche; Fig. 1 * -- | 1 | |
| A | US - A - 4 680 774 (KLEIN et al.) * Gesamt * -- | 1 | |
| A | US - A - 4 752 767 (MAIO et al.) * Fig. 6; Zusammenfassung * -- | 1 | |
| A | US - A - 4 843 392 (GULCZYNSKI) * Gesamt * -- | 1 | |
| P,A | US - A - 4 947 172 (SUZUKI) * Gesamt * ---- | 1 | |

RECHERCHIERTE SACHGEBIETE (Int Cl⁵)

H 03 M 1/00
H 03 M 13/00

Der vorliegende Recherchenbericht wurde für alle Patentansprüche erstellt

| Recherchenort | Abschlußdatum der Recherche | Prüfer |
|---|---|---|
| WIEN | 23-11-1990 | BAUMANN |